# EUROPEAN PATENT APPLICATION

(11) **EP 1 161 130 A2**
(43) Date of publication of application: **05.12.2001**
(21) Application number: 01304831.9
(22) Date of filing: 01.06.2001
(51) Int. Cl.: H05K 13/04

(54) **Electric-component mounting apparatus**

(30) Priority: 02.06.2000 JP 2000166385
(71) Applicant: Fuji Machine Mfg. Co., Ltd., Chiryu-shi, Aichi-ken (JP)
(72) Inventor: Suhara, Shinsuke, c/o Fuji Machine MFG. Co., Ltd., Chiryu-shi, Aichi-ken (JP)
(74) Representative: Moir, Michael Christopher

(57) **Abstract**

An apparatus (8) for mounting an electric component (94) on a circuit substrate (350), the apparatus including a nozzle-holding member (74) which holds a suction nozzle (90) applying a suction to the component and thereby holding the component; a displaceable member (20) which supports the nozzle-holding member and is displaceable in a first direction intersecting an axial direction of the nozzle; a displacing device (32) which displaces the displaceable member in the first direction so that the component held by the nozzle is transferred in the first direction and is positioned at a position above the substrate; a moving device (32, 40, 120) which moves, relative to the displaceable member, the nozzle-holding member downward in a second direction parallel to the axial direction of the nozzle so that the component held by the nozzle is mounted on the substrate; and a guiding device (58) which is provided between the nozzle-holding member and the displaceable member and guides a downward movement of the nozzle-holding member relative to the displaceable member in the second direction, the guiding device including two guide members (46, 50) which are engaged with each other, one (46) of the two guide members being supported by the nozzle-holding member, the other guide member (50) being supported by the displaceable member, so that the one guide member is movable relative to the other guide member, along a straight line, one or each (46, 50) of the two guide members being a ceramic.

## Description

### BACKGROUND OF THE INVENTION

### Field of the Invention

The present invention relates to an electric-component (EC) mounting apparatus and an EC mounting system, and particularly to the art of mounting, with improved accuracy, electric components (ECs), in particular, electronic components.

### Discussion of Related Art

Japanese Patent Document No. 6-342998 discloses an EC mounting apparatus which includes an index table which is rotatable about a vertical axis line; and a plurality of suction nozzles which are provided on the index table. A plurality of guide blocks are fixed to an outer circumferential surface of the index table such that the guide blocks, each taking a vertical posture, are equiangularly spaced from each other about the axis line of the table, and a plurality of guide rails are fitted in the guide blocks, respectively, such that each of the guide rails is vertically movable relative to a corresponding one of the guide blocks. Each of the guide rails supports a nozzle-holding member which holds a suction nozzle. Thus, the nozzle-holding members are supported by the index table such that the nozzle-holding members are equiangularly spaced from each other and are vertically movable. When the index table is intermittently rotated at the same angular pitch as that at which the nozzle-holding members are spaced from each other, the nozzle-holding members are sequentially stopped at a plurality of stop positions including an EC-suck position where the suction nozzle of each nozzle-holding member sucks and holds an EC supplied by an EC supplying device, and an EC-mount position where the suction nozzle mounts the EC on a printed wiring board (PWB). At each of the EC-suck and EC-mount positions, there is provided a nozzle elevating and lowering device which elevates and lowers the guide rail, and accordingly the nozzle-holding member, so that the suction nozzle is elevated and lowered in directions parallel to an axis line thereof to suck and hold an EC or mount the EC. The elevating and lowering of the nozzle-holding members are guided by the guide rails and the guide blocks, and conventionally the guide rails and blocks have been made of steel, such as S50C or SUS440.

However, the EC mounting apparatus employing the steel-made guide rails and blocks has various problems.

For example, since steel has a great mass, an inertial mass of the index table with respect to its rotation direction is so large that the index table is subjected to a great impact when the rotation thereof is started or stopped. Therefore, the life expectancy of constituent elements of the EC mounting apparatus is short. In addition, a large-size servomotor is needed as a drive source of an intermittently rotating device which intermittently rotates the index table, which leads to increasing the cost of the apparatus. In particular, the EC mounting apparatus disclosed in the above-indicated document employs the plurality of suction nozzles, and accordingly the index table thereof has a great inertial mass, which leads to lowering the life expectancy of the constituent members and needing a large-size servomotor.

Moreover, some sorts of steel, such as S50C or SUS440, have a nature that internal friction thereof is small and accordingly vibration thereof is not easily attenuated. Therefore, after the rotation of the index table is stopped, the guide rails and blocks continue vibrating in directions of movement of the suction nozzles, that is, directions intersecting the respective axial directions of the nozzles. Consequently a free end portion of each suction nozzle continues vibrating, which may lead to sucking and holding an EC, or mounting the EC, with some problems. When the each nozzle sucks and holds an EC, a position of the nozzle relative to the EC may be largely deviated so that the nozzle may suck and hold the EC at a position largely deviated from the center of EC, or may even fail to hold the EC. When the each nozzle mounts the EC, a position of the EC relative to an EC-mount place on a PWB may be largely deviated so that the EC may be mounted on the PWB with low accuracy. The vibration of the guide rails or the like may be caused by the inertial forces of the nozzle-holding members produced when the holders are accelerated or decelerated in the directions intersecting the axial directions of the suction nozzles, or may be caused by the vibration transmitted from the EC supplying device or the like via the main frame of the apparatus. In either case, the vibration of the guide rails or the like adversely influences the accuracy with which each suction nozzle sucks and holds an EC or mounts the EC.

The above-described problems occur to not only the EC mounting apparatus employing the index table which supports the suction nozzles such that each of the nozzles is vertically movable, but also other sorts of EC mounting apparatuses, such as an apparatus employing an X-Y robot which moves a suction nozzle to an arbitrary position.

### SUMMARY OF THE INVENTION

It is therefore an object of the present invention to provide an electric-component mounting apparatus which enjoys a high life expectancy and a small size, and which holds and mounts an electric component with high accuracy.

In a first aspect the present invention provides apparatus for mounting an electric component on a circuit substrate, the apparatus comprising:
nozzle-holding means for holding a suction nozzle for applying suction to the electric component to thereby hold the component;
support means for supporting the nozzle-holding means and which is moveable in a first direction intersecting an axis of the suction nozzle;
displacing means for displacing the support means in the first direction so as to transfer a component held by the suction nozzle to a position above the circuit substrate;
moving means for moving, relative to the support means, the nozzle-holding means in a second direction substantially parallel to the axial direction of the suction nozzle to enable the electric component held by the nozzle to be mounted on the circuit substrate; and
guiding means which is provided between the nozzle-holding means and the support means for guiding the movement of the nozzle-holding means relative to the support means in the second direction, the guiding means including two guide members, one of the two guide members being supported by the nozzle-holding means, the other guide member being supported by the support means, so that said one guide member is movable relative to said other guide member, at least one of the two guide members being formed from ceramic material.

According to a preferred embodiment, there is provided an apparatus for mounting an electric component on a circuit substrate supported by a substrate-supporting device, the apparatus comprising a nozzle-holding member which holds a suction nozzle applying a suction to the electric component and thereby holding the component; a displaceable member which supports the nozzle-holding member and which is displaceable in a first direction intersecting an axial direction of the suction nozzle; a displacing device which displaces the displaceable member in the first direction so that the electric component held by the suction nozzle is transferred in the first direction and is positioned at a position above the circuit substrate supported by the substrate-supporting device; a moving device which moves, relative to the displaceable member, the nozzle-holding member downward in a second direction parallel to the axial direction of the suction nozzle so that the electric component held by the nozzle is mounted on the circuit substrate; and a guiding device which is provided between the nozzle-holding member and the displaceable member and which guides a downward movement of the nozzle-holding member relative to the displaceable member in the second direction, the guiding device including two guide members which are engaged with each other, one of the two guide members being supported by the nozzle-holding member, the other guide member being supported by the displaceable member, so that the one guide member is movable relative to the other guide member, along a straight line, at least one of the two guide members being a ceramic.

The displaceable member may be an intermittently rotatable member ;
a movable member which is movable in directions each having two components respectively parallel to two directions perpendicular to each other on a plane parallel to a surface of the circuit substrate; or a linearly movable member which is linearly movable in a single direction.

One of the two guide members may be elongate and is longer than the other. The elongate guide member may be a guide rail, or a guide rod. In the case where one of the guide members is a guide rail, the other guide member may be a guide block; and in the case where one of the guide members is a guide rod, the other guide member may be a tubular member and is fitted on an outer surface of the guide rod. The two guide members may be directly engaged with each other, or may be indirectly engaged with each other via rolling members such as balls, slide members such as linings, or bearings.

The specific gravity of ceramic products is smaller than that of steel. For example, the specific gravity of the ceramic product containing silicon nitride as its main component is 3.2. Thus, the inertial mass of the displaceable member when the displaceable member is displaced in the first direction is small. Therefore, when the displacement of the displaceable member is started or stopped, only a small inertial force is exerted to the displaceable member, which contributes to increasing the life expectancy of various constituent members which are influenced by the inertial force.

In addition, the displacing device which displaces the displaceable member can employ a small-size drive source, which contributes to reducing the size and cost of the apparatus.

Moreover, the ceramic product has an excellent vibration-attenuation nature. If at least one of the two guide members is provided by a ceramic product, the vibration of the one guide member, produced because of the inertial mass of the nozzle-holding member, etc., when the displacement of the displaceable member is started or stopped in the direction intersecting the axial direction of the suction nozzle, easily attenuates. In addition, the one guide member reduces the transmission, to the nozzle-holding member, of the vibration produced by an apparatus, such as an EC supplying device, other than the EC mounting apparatus, and thereby reduces the vibration of a free end portion of the suction nozzle when the nozzle sucks or mounts an EC. Thus, the number of failures to suck ECs and the number of failures to mount ECs are decreased, and accordingly the reliability of the EC mounting apparatus or the accuracy of mounting of ECs is improved. An inertial force or a vibration is increased as the acceleration and deceleration of the displaceable member are increased. However, since the vibration easily attenuates, the acceleration and deceleration of the displaceable member can be increased to shorten the time needed to mount an EC and thereby improve the efficiency of mounting of ECs.

The ceramic product has a high degree of rigidity, e.g., one and half times as hard as steel. Therefore, the amount of displacement of the ceramic product upon vibration is small. In this regard, too, the vibration of the free end portion of the suction nozzle at the time of sucking or mounting an EC is small, which contributes to improving the accuracy of sucking or mounting of ECs.

Since the ceramic product is so rigid, the ceramic product enjoys a longer life expectancy than that of a steel product, thereby contributing to improving the life expectancy of the apparatus.

Since the ceramic product does not rust, the surfaces of the ceramic product does not need any treatments, which contributes to simplifying the production of the apparatus and lowering the production cost of the apparatus.

Preferably, the one guide member comprises one of an elongate guide rail and a guide block which is engaged with the guide rail such that the one of the guide rail and the guide block is movable relative to the other of the rail and the block in only a lengthwise direction of the rail, and the other guide member comprises the other of the rail and the block.

Preferably, the apparatus comprises a plurality of nozzle-holding members each of which holds a corresponding one of a plurality of suction nozzles, the displaceable member comprises an intermittently rotatable member which supports the nozzle-holding members and which is intermittently rotatable about an axis line at a first regular angular pitch, in the first direction intersecting the axial direction of each of the suction nozzles held by the nozzle-holding members, the displacing device comprises an intermittently rotating device which intermittently rotates the intermittently rotatable member in the first direction so that the electric component held by each of the suction nozzles is transferred in the first direction, and is positioned at a position above the circuit substrate supported by the substrate-supporting device, the moving device moves each of the nozzle-holding members downward in the second direction so that the electric component held by the suction nozzle held by the each nozzle-holding member is mounted on the circuit substrate, and each of a plurality of guiding devices is provided between the intermittently rotatable member and a corresponding one of the nozzle-holding members, and guides a downward movement of the one nozzle-holding member in the second direction, the guiding devices including a plurality of guide blocks which are fixed to an outer circumferential surface of the intermittently rotatable member such that the guide blocks are equiangularly spaced from each other at a second regular angular pitch equal to the first angular pitch; and a plurality of guide rails each of which is attached to a corresponding one of the nozzle-holding members.

The axis line of rotation may be an axis line parallel to, or inclined relative to, a plane perpendicular to a surface of the circuit substrate.

The EC mounting apparatus according to this feature employs a plurality of pairs of guide blocks and guide rails, and a plurality of suction nozzles. Therefore, the sum of respective masses of those guide blocks and rails is great. However, since at least one of each pair of guide block and rail is provided by a ceramic product, the apparatus can very effectively enjoy a mass-reduction effect and a vibration-attenuation effect.

In the present EC mounting apparatus, the intermittently rotatable member supports a plurality of suction nozzles and, when the rotatable member is intermittently rotated, each of the suction nozzles is sequentially stopped at each of operation positions. Thus, the plurality of suction nozzles can concurrently perform a plurality of operations. Therefore, the present apparatus can advantageously shorten a cycle time corresponding to a single operation, thereby improving the efficiency of mounting of ECs. The cycle time is defined as a time duration from a time when one of the suction nozzles is stopped at one of a plurality of stop positions to a time when the one nozzle is moved to, and stopped at, another stop position next to the one stop position. Therefore, if at least one of each pair of guide block and rail is provided by a member having an excellent vibration-attenuation nature, the acceleration and deceleration of each intermittent rotation can be increased to shorten the cycle time and thereby improve the EC-mounting efficiency.

Preferably, at least the guide rail is a ceramic.

In many cases, the guide rail has a greater dimension in the axial direction of the suction nozzle, and a greater mass, than those of the guide block. Therefore, if the guide rail is provided by a ceramic product, a higher mass-reduction effect and a higher vibration-attenuation effect are enjoyed.

In the case where the guide rail is attached to the nozzle-holding member, the guide rail provided by the ceramic product is elevated and lowered. Therefore, an inertial force produced when the suction nozzle is elevated and lowered is small, which leads to improving the accuracy with which the upward and downward movement of the nozzle is controlled. For example, in the case where an elevating and lowering device which elevates and lowers the nozzle comprises a cam device including a cam and a cam follower, a position where the acceleration of downward movement of the nozzle is ended, and a position where the deceleration of downward movement of the same is started are defined by the shape of the cam and, the smaller the inertial force is, the more faithful the acceleration and the deceleration are to the shape of the cam. Therefore, when the suction nozzle sucks and holds an EC, the nozzle contacts the EC at a sufficiently low speed, without applying an excessively large impact thereto. Thus, the EC is prevented from being filliped or broken by the impact, and the rate at which the nozzle normally holds an EC is increased. When the nozzle mounts an EC, the EC would be damaged, or would come off the nozzle and fall onto a place different from a prescribed EC-mount place on a PWB, if the EC contacts the PWB with an excessively large impact. However, if the inertial mass of the portion which is elevated and lowered with the nozzle is small, the rate at which the nozzle fails to normally mount an EC is decreased.

Preferably, the nozzle-holding member includes a shank portion having a circular transverse cross section, and the apparatus further comprises a tubular member in which the shank portion is fitted such that the shank portion is rotatable relative to the tubular member and is not movable in an axial direction thereof relative to the tubular member, the guide rail being fixed to the tubular member.

Preferably, at least one of the shank portion and the tubular member is a ceramic.

Since at least one of the guide rail and the guide block is provided by a ceramic product and at least one of the shank portion and the tubular member is provided by a ceramic product, the vibration produced by the inertial mass of the nozzle-holding member when the movement of the suction nozzle is started or stopped easily attenuates, or the transmission of vibration to the nozzle diminishes. In addition, the total mass of the intermittently rotatable member decreases, which leads to improving the life expectancy of the rotatable member.

Preferably, at least the shank portion is a ceramic.

The suction nozzle is held by the nozzle-holding member including a shank portion, and the shank portion is rotated to rotate the nozzle. Since the shank portion is provided by a ceramic product, the moment of inertia produced when the nozzle is rotated is small, which leads to improving an accuracy with which the rotation of the nozzle is stopped at a prescribed rotation position, or shortening a time needed to rotate the same to a prescribed rotation position.

In a second aspect the present invention provides apparatus for mounting an electric component on a circuit substrate, the apparatus comprising:
nozzle-holding means for holding a suction nozzle for applying suction to the electric component to thereby hold the component;
support means for supporting the nozzle-holding means and which is movable in a first direction intersecting an axis of the suction nozzle;
means for rotating the nozzle-holding member so as to rotate the suction nozzle about an axis line thereof;
moving means for moving the nozzle-holding means relative to the circuit substrate to enable the electric component held by the suction nozzle to be mounted on the circuit substrate; and
means for connecting the nozzle-holding means to the support means such that the nozzle-holding means is rotatable relative to the support means, the connecting means including two members which are fitted together such that one member which is rotatable relative to the other member, at least one of the two members being formed from ceramic material.

According to an a preferred embodiment, invention, there is provided an apparatus for mounting an electric component on a circuit substrate supported by a substrate-supporting device, the apparatus comprising a nozzle-holding member which holds a suction nozzle applying a suction to the electric component and thereby holding the component; a displaceable member which supports the nozzle-holding member and which is displaceable in a first direction intersecting an axial direction of the suction nozzle; a rotating device which rotates the nozzle-holding member to rotate the suction nozzle about an axis line thereof by an arbitrary angle; a moving device which moves the nozzle-holding member relative to the circuit substrate supported by the substrate-supporting device, so that the electric component held by the suction nozzle is mounted on the circuit substrate; and a connecting device which connects the nozzle-holding member to the displaceable member such that the nozzle-holding member is rotatable relative to the displaceable member, the connecting device including two members which are fitted in each other and one of which is rotatable relative to the other member, at least one of the two members being a ceramic.

The two members one of which is rotatable relative to the other member may be directly fitted in, or on, each other, or indirectly fitted in, or on, each other via rolling members such as balls, slide members such as linings, or bearings. In the case where the two members are fitted in, or on, each other via one or more bearings and each bearing includes an inner ring, an outer ring, and rolling members such as balls, it can be said that the two members do not comprise the inner or outer ring, or alternatively that the two members comprise the inner and outer rings, respectively, or otherwise that the two members consist of the inner and outer rings, respectively.

Rotation of the suction nozzle about its axis line may be utilized to eliminate a rotation-positional error of the nozzle, i.e., an angular error of the nozzle about its center, or change a current posture of the nozzle about its center. Since at least one of the two members of the connecting device is provided by a ceramic product, the vibration produced by the inertial mass of the nozzle-holding member when the movement of the displaceable member in the direction intersecting the axial direction of the nozzle is started or stopped easily attenuates, or the transmission, to the nozzle- holding member, of the vibration produced by a device, such as the EC supplying device, other than the EC mounting apparatus diminishes. Thus, the accuracy with which the nozzle mounts an EC is improved, or the time needed for the nozzle to mount an EC is shortened. In addition, if one of the two members that is rotated is provided by a ceramic product, the moment of inertia produced when the nozzle is rotated is small, which leads to improving the accuracy with which the rotation of the nozzle is stopped at a prescribed rotation position, or shortening the time needed to rotate the same to a prescribed rotation position.

In a third aspect the present invention provides apparatus for mounting an electric component on a circuit substrate, the apparatus comprising:
holding means for receiving a component holder for holding an electric component;
support means for supporting a circuit substrate on which an electric component held by the component holder is to be mounted;
displacing means for displacing at least one of the holding means and the support means relative to the other along a plane substantially parallel to a surface of a circuit substrate to be supported by the support means;
moving means for moving at least one of the holding means and the support means relative to the other in a direction perpendicular to a surface of a circuit substrate to be supported by the support means; and
at least one of the displacing means and the moving means including guiding means for guiding a relative displacement of the holding means and the support means by the displacing means and a relative movement of the holding means and the support means by the moving means, the guiding means including an elongate first member and a second member engaging the first member such that at least one of the first and second members is movable relative to the other in a lengthwise direction of the first member, at least one of the first and second members being formed from ceramic material.

According to a preferred embodiment, there is provided an a system for mounting an electric component on a circuit substrate, the system comprising a holder-holding member to which a component holder which holds the electric component is detachably attached; a substrate-supporting device which supports the circuit substrate on which the electric component held by the component holder is to be mounted; a displacing device which displaces at least one of the holder-holding member and the substrate-supporting device relative to the other of the holder-holding member and the substrate-supporting device, to an arbitrary position, along a plane parallel to a surface of the circuit substrate supported by the substrate-supporting device; a moving device which moves at least one of the holder-holding member and the substrate-supporting device toward, and away from, the other of the holder-holding member and the substrate-supporting device, in opposite directions perpendicular to the surface of the circuit substrate supported by the substrate-supporting device; and at least one of the displacing device and the moving device including a guiding device which guides a corresponding one of a relative displacement of the holder-holding member and the substrate-supporting device caused by the displacing device and a relative movement of the holder-holding member and the substrate-supporting device caused by the moving device, the guiding device including an elongate first member and a second member which is engaged with the first member such that at least one of the first and second members is movable relative to the other of the first and second members in a lengthwise direction of the first member, at least one of the first and second members being a ceramic.

The component holder may be a suction nozzle which applies a suction or negative pressure to an EC and thereby holds the same, or a chuck which includes a plurality of jaws and holds and releases an EC with the jaws.

The elongate first member may be a guide rail or a guide rod. In the case where the first member is a guide rod, the second member may be one which is engaged with the first members such that the second member fully surrounds the guide rod; and in the case where the first member is a guide rail, the second member may be one which is engaged with the first member such that the second member allows at least one side surface of the guide rail to be exposed.

The displacing device may be a device which translates the holder-holding member, relative to the circuit substrate, in directions each having two components parallel to two directions perpendicular to each other on a plane parallel to a surface of the substrate; a device which linearly moves one of the circuit substrate and the holder-holding member in one of two directions perpendicular to each other on the plane, and linearly moves the other of the substrate and the holder-holding member in the other direction; or a device which translates the circuit substrate in directions each having two components parallel to two directions perpendicular to each other on the plane. In the case where the holder-holding member is moved along a plane or a straight line, it is possible to additionally move the holder-holding member in a manner different from the manner in which holder-holding member is moved along the plane or the line. For example, it is possible to additionally translate the intermittently rotatable member described above, in directions each having two components parallel to two directions perpendicular to each other on the plane. In this case, the holder-holding member is displaced to an EC-mount place by a composite motion including the intermittent rotation, and the translation, of the intermittently rotatable member. The axis line about which the intermittently rotatable member is rotated may be perpendicular to the plane, or inclined relative to a plane perpendicular to the surface of the substrate. In either case, the holder-holding member is displaced to an arbitrary position on the plane by the intermittent rotation, and the translation parallel to the plane, of the intermittently rotatable member. Therefore, an intermittently rotating device which intermittently rotates the intermittently rotatable member, and a translating device which translates the intermittently rotatable member cooperate with each other to provide the displacing device described above. In the case where the intermittently rotatable member is only intermittently rotated, the intermittently rotating device cooperates with a circuit-substrate moving device which moves the circuit substrate, to provide the displacing device recited in the present feature.

The moving device may be a device which moves the holder-holding member relative to the substrate supporting device; a device which moves the substrate supporting device relative to the holder-holding member; or a device which moves both the holder-holding member and the substrate supporting device relative to each other.

Irrespective of either the displacement parallel to the surface of the circuit substrate or the movement in the direction perpendicular to the same, the vibration of the holder-holding member produced when the displacement or movement of the member is started or stopped easily attenuates, or the transmission, to the holder-holding member, of the vibration produced by devices, such as an EC supplying device or a circuit-substrate moving device, other than the EC mounting apparatus, diminishes, if at least one of the first and second members at least one of which is moved relative to the other for the displacement or movement of the member is provided by a ceramic product.

Irrespective of either the displacement or the movement, the vibration produced when the displacement or movement of the circuit substrate is started or stopped easily attenuates, or the transmission of vibration thereto from other devices diminishes, if at least one of the first and second members at least one of which is moved relative to the other for the displacement or movement of the substrate supporting device is provided by a ceramic product. Thus, an accuracy with which the circuit substrate and the holder-holding member are positioned relative to each other is improved, and an accuracy with which an EC is mounted at a prescribed EC-mount place is improved.

Preferably, the first member is a ceramic.

Preferably, the ceramic contains silicon nitride as a main component thereof.

Preferably, the guiding device further comprises a plurality of rolling members, and the guide rail and the guide block are engaged with each other via the rolling members.

The rolling members may be provided by balls. Since the guide rail and the guide block are engaged with each other via the rolling members, a resistance to the relative movement of the guide rail and block is small, which leads to improving the life expectancy of the guide rail and block.

In addition, basically, the guide rail and the guide block can be used without lubricant, and accordingly do not need maintenance (i.e., replenishment of the lubricant).

This feature may be employed by the EC mounting apparatus whose guiding device includes a guide rod and a tubular member.

The present invention has been developed to solve a problem with an EC mounting apparatus, on one hand, but it is applicable to any other sort of apparatus which suffers from the same problem, on the other hand.

Accordingly, in a fourth aspect the present invention provides guiding apparatus, comprising:
an elongate first member; and
a second member engaging the first member such that at least one of the first and second members is movable relative to the other in only a lengthwise direction of the first member;
at least one of the first and second members being formed from ceramic material.

According to a preferred embodiment, there is provided a guiding apparatus, comprising an elongate first member; and a second member which is engaged with the first member such that at least one of the first and second members is movable relative to the other of the first and second members in only a lengthwise direction of the first member, at least one of the first and second members being a ceramic.

Preferably, the first member comprises a guide rail, and the second member comprises a guide block.

Alternatively, the first member may be provided by a guide rod, and the second member may be provided by a tubular member which is fitted on an outer surface of the guide rod.

Preferably, at least the first member is a ceramic.

Preferably, the apparatus further comprises a plurality of rolling members, and the first and second members are engaged with each other via the rolling members.

Preferably, the plurality of rolling members comprises a plurality of balls.

Preferably, each of the rolling members is a ceramic.

### BRIEF DESCRIPTION OF THE DRAWINGS

The above and other objects, features, advantages and technical and industrial significance of the present invention will be better understood by reading the following detailed description of preferred embodiments of the invention, when considered in connection with the accompanying drawings, in which:
Fig. 1 is a partly cross-sectioned, front elevation view of an electric-component (EC) mounting apparatus to which the present invention is applied.
Fig. 2 is a plan view for explaining a plurality of stop position of the EC mounting apparatus and showing an image-taking device which is provided at an EC-posture-detect position as one of the stop positions;
Fig. 3 is a partly cross-sectioned, front elevation view of an EC mounting unit, and an elevator member of an EC-mounting-unit elevating and lowering device provided at an EC-receive position, of the EC mounting apparatus;
Fig. 4 is a plan view of a guide rail and a guide block which guide upward and downward movements of a nozzle-holding member of the EC mounting unit;
Fig. 5 is a cross-sectioned, front elevation view of a suction nozzle of the EC mounting unit;
Fig. 6 is a partly cross-sectioned, front elevation view of a wiring-board supporting and moving device provided at an EC-mount position, as one of the stop positions, where the EC mounting unit is stopped;
Fig. 7 is a plan view of a height-position adjusting device of the wiring-board supporting and moving device; and
Fig. 8 is a diagrammatic view of a control device which controls an EC mounting system including the EC mounting apparatus.

### DETAILED DESCRIPTION OF PREFERRED EMBODIMENTS

Hereinafter, there will be described an embodiment of the present invention in detail by reference to the drawings. An electric-component (EC) mounting apparatus 8 to which the present invention is applied has a construction similar to that of an EC mounting apparatus disclosed in Japanese Patent Document No. 6-342998. The same portions of the two EC mounting apparatuses are briefly illustrated and described.

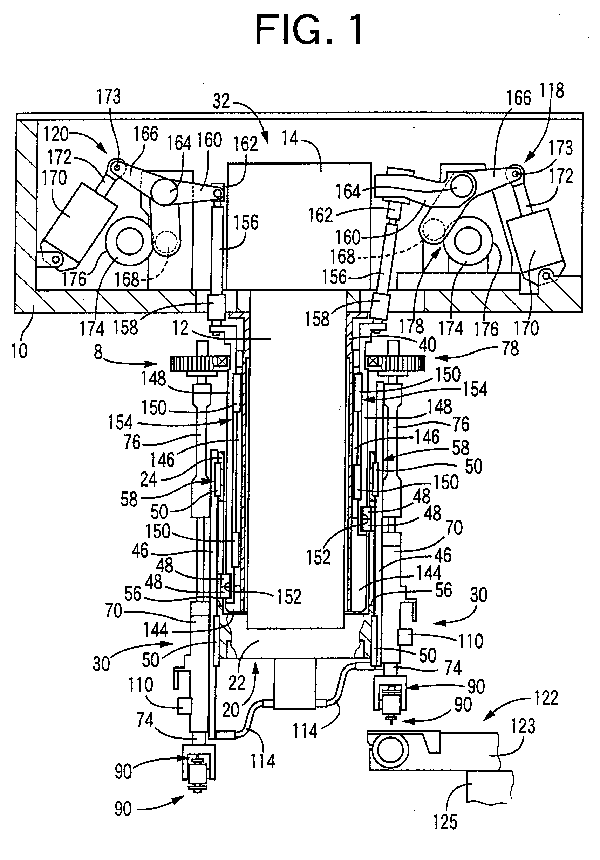

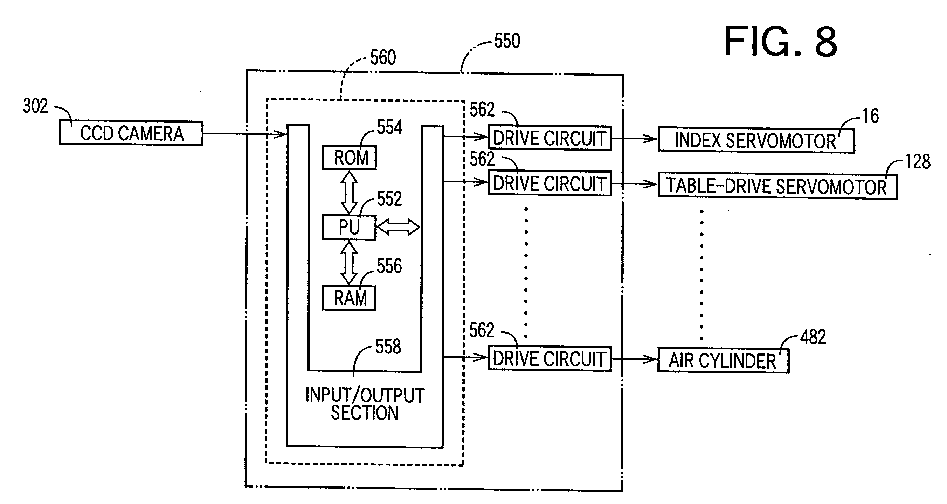

In Fig. 1, reference numeral 10 designates a frame which supports a rotary shaft 12 such that the rotary shaft 12 is rotatable about an axis line, e.g., a vertical axis line in the present embodiment. The rotary shaft 12 is rotated by a rotary-shaft drive device 14 which includes a roller gear and a roller gear cam, both not shown, and an index servomotor 16 (Fig. 8). When the roller gear cam is rotated at a prescribed speed in a prescribed direction by the index servomotor 16, a plurality of rollers of the roller gear sequentially engage a cam rib of the roller gear cam, so that the rotary shaft 12 is rotated intermittently at a prescribed angular pitch about the vertical axis line.

An index table 20 as an intermittently rotatable member as a sort of displaceable member is fixed to a lower end portion of the rotary shaft 12 which projects downward from the frame 10. The index table 20 has a generally cylindrical shape, and includes a bottom portion 22 which is fixed to the rotary shaft 12, and a cylindrical portion 24 which extends toward the frame 10. The cylindrical portion 24 supports a plurality of EC mounting units 30, e.g., sixteen EC mounting units 30 in the present embodiment, such that the EC mounting units 30 are equiangularly spaced from one another on a circle whose center is located on the axis line about which the rotary shaft 12 is rotated. When the rotary shaft 12 is rotated, the index table 20 is rotated intermittently at the prescribed angular pitch equal to an angular pitch at which the sixteen EC mounting units 30 are supported. The rotary shaft 12 and the rotary-shaft drive device 14 cooperate with each other to provide the intermittently rotating device or a displaceable-member drive device.

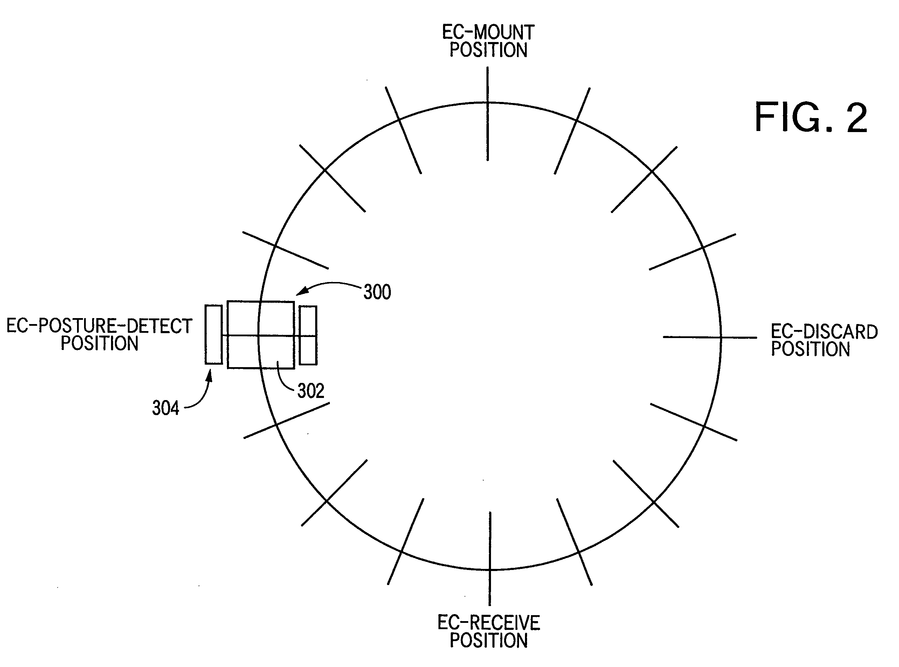

Thus, each EC mounting unit 30 is stopped at sixteen stop positions including a plurality of operation positions and a plurality of detection positions. The rest of the stop positions are resting positions where no operation or detection is performed. In the present embodiment, as schematically illustrated in Fig. 2, the operation positions include an EC-receive position, an EC-mount position, and an EC-discard position; and the detection positions include an EC-posture-detect position. When the index table 20 is intermittently rotated, the sixteen EC mounting units 30 are revolved about the vertical axis line, while being sequentially moved to, and stopped, at the sixteen stop positions provided on the locus of revolution thereof. The rotary shaft 12, the rotary-shaft drive device 14, and the index table 20 cooperate with one another to provide a nozzle revolving device 32. The nozzle revolving device 32 also functions as an intermittently rotating device which intermittently rotates a suction nozzle, described later, which is held by each EC mounting unit 30.

The operation positions include, in addition to the above-described EC-receive position and other positions, an EC-posture-correct position, an EC-mounting-unit-posture-correct position, and a nozzle-select position where an EC-posture correcting device, an EC-mounting-unit-posture correcting device, and a nozzle selecting device are provided, respectively. The detection positions include, in addition to the EC-posture-detect position, a suction-nozzle-detect position where a suction-nozzle detecting device is provided. However, since those positions are not relevant to the present invention, no illustration or description is provided here.

As shown in Fig. 1, a cylindrical cam 40 is fixed to a lower surface of the frame 10. The cylindrical cam 40 is externally fitted around the rotary shaft 12, such that a space is left between the cam 40 and the shaft 12 in a radial direction of the cam 40 and that a lower portion of the cam 40 is inserted in a space present between the shaft 12 and the cylindrical portion 24 of the index table 20. A cam groove (not shown) is formed in the lower portion of the cam 40, such that the cam groove opens in an outer circumferential surface of the cam 40. A pair of rollers 48 which are attached to each of sixteen guide rails 46 each as a guide member are engaged with the cam groove, such that each of the rollers 48 is rotatable in the cam groove.

Each of the sixteen guide rails 46 has an elongate shape. In the present embodiment, each guide rail 46 is a ceramic product containing silicon nitride as a main component thereof, and has a specific gravity of 3.2. The same number of, i.e., sixteen, pairs of guide blocks 50 each as a guide member as the number of the EC mounting units 30 are fixed to an outer circumferential surface of the index table 20, such that the sixteen pairs of guide blocks 50 are equiangularly spaced from one another. Thus, the sixteen pairs of guide blocks 50 are fixed to the index table 20, at the same angular pitch as the angular pitch at which the index table 20 is intermittently rotated. The two guide blocks 50 of each pair are distant from each other in a vertical direction parallel to the axis line about which each EC mounting unit 30 is revolved, and the guide rail 46 is fitted in the two guide blocks 50 such that the rail 46 is movable relative to the blocks 50 in a lengthwise direction of the rail 46 that is a vertical direction.

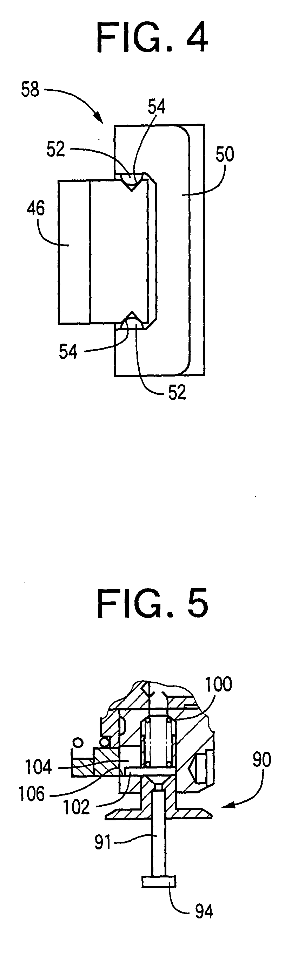

As shown in Fig. 4, each guide block 50 has a generally U-shaped transverse cross section, and holds a plurality of balls 52 each as a rolling member such that the balls 52 are circulateable. The guide rail 46 has a pair of grooves 54 each of which has a V-shaped cross section and extends parallel to the lengthwise direction of the rail 46. The balls 52 are fitted in the grooves 54. The guide rail 46 is engaged with the guide blocks 50 via the balls 52, such that the rail 46 is movable relative to the blocks 50 in the lengthwise direction of the rail 46. A pair of side walls of each U-shaped guide block 50 prevent the guide rail 46 from being moved in a widthwise direction thereof, and the engagement of the balls 52 and the grooves 54 prevents the rail 46 from being moved in a direction perpendicular to the lengthwise and widthwise directions thereof, i.e., moved off the each block 50. Thus, each guide rail 46 is engaged with the corresponding pair of guide blocks 50 such that the each rail 46 is movable relative to the blocks 50 in only the lengthwise direction of the rail 46. Thus, each guide rail 46 and the corresponding pair of guide blocks 50 are engaged with each other such that the each rail 46 is movable relative to the blocks 50 along a straight line, e.g., a vertical straight line in the present embodiment. Each guide rail 46, the corresponding pair of guide blocks 50, and the corresponding balls 52 cooperate with one another to provide a guiding device 58 which guides a downward movement of the corresponding EC mounting unit 30 including a nozzle-holding member and a suction nozzle, both described later, in a direction parallel to an axial direction of the suction nozzle, or a downward movement of the nozzle-holding member in the same direction. It can be said that each guide rail 46 belongs to the corresponding EC mounting unit 30.

The above-mentioned pair of rollers 48 are attached to a lengthwise intermediate portion of the guide rail 46, such that each roller 48 is rotatable about a horizontal axis line perpendicular to the axis line about which the index table 20 is rotated. The pair of rollers 48 are rotatably fitted in the cam groove of the cylindrical cam 40, via an elongate hole 56 which is formed in a portion of the cylindrical portion 24 between the pair of guide blocks 50 and extends in a vertical direction.

The height position of the cam groove continuously changes in a circumferential direction of the cylindrical cam 40. When the index table 20 is rotated and the EC mounting units 30 are revolved, each pair of rollers 48 are moved in the cam groove, so that the corresponding EC mounting unit 30 is elevated and lowered. In the present embodiment, the cam groove is so formed that each EC mounting unit 30 reaches an upward-movement-end position at the EC-receive position, reaches a downward-movement-end position at the EC-mount position, and moves horizontally around each of the EC-receive position and the EC-mount position.

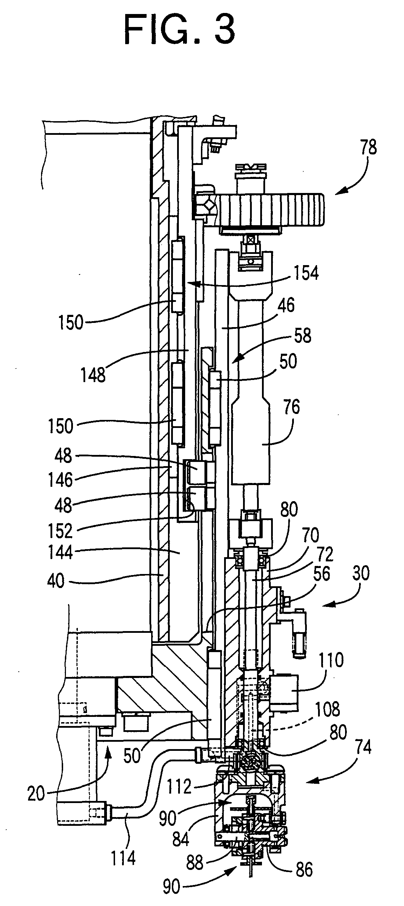

A sleeve 70 as a tubular member is fixed to a lower portion of an outer surface of the guide rail 46. As shown in Fig. 3, a rod 72 is fitted in the sleeve 70 via a pair of bearings 80, such that the rod 72 takes a vertical posture, i.e., a posture parallel to the axis line about which the suction nozzles are revolved, and such that the rod 72 is rotatable about its own axis line and is not movable relative to the sleeve 70 in an axial direction of the rod 72. The rod 72 has a circular transverse cross section. In the present embodiment, the rod 72 provides a shank portion of a nozzle-holding member 74 as a holder-holding member which holds a suction nozzle as a component holder; and the sleeve 70 and the rod 72 cooperate with each other to provide a connecting device which connects the nozzle-holding member 74 to the index table 20 such that the nozzle-holding member 74 is rotatable relative to the table 20. In the present embodiment, the nozzle-holding member 74 of each EC mounting unit 30 is rotated, at the EC-posture-correct position, about its own axis line by the EC-posture correcting device, and the rotation position of the holder 74 about the axis line is returned, at the EC-mounting-unit-posture-correct position, to an original position before correction, by the EC-mounting-unit-posture correcting device. A portion of the rotation of the holder 74 is effected concurrently with a portion of the rotation of the index table 20. To this end, the rod 72 receives a rotating or driving force from the EC-posture correcting device or the EC-mounting-unit-posture correcting device, via a rotation transmitting member 76, while the rod 72 is permitted to be elevated or lowered. A rotating device 78 rotates the rotation transmitting member 76 about an axis line parallel to the axis line about which the index table 20 is rotated, independent of the rotation of the table 20. However, those elements are not relevant to the present invention, no illustration or description thereof is provided here.

As shown in Fig. 3, an attachment member 84 is fixed to a lower end of the rod 72 that projects downward out of the sleeve 70. The attachment member 84 supports a rotary holder 86 via a support shaft 88 such that the rotary holder 86 is rotatable about a horizontal 'axis line perpendicular to an axis line of the rod 72. The attachment member 84, the rotary holder 86, and the rod 72 cooperate with one another to provide the nozzle-holding member 74. The rotary holder 86 holds a plurality of suction nozzles 90 such that the suction nozzles 90 are equiangularly spaced from each other about the support shaft 88 and extend in radial directions of the same 88. The rotary holder 86 cooperates with the nozzle-holding member 74 to provide the EC mounting unit 30. When the rotary holder 86 is rotated about the support shaft 88, one of the suction nozzles 90 is selectively moved to, and positioned at, an operative position where the one nozzle 90 is oriented downward and an axis line of the one nozzle 90 coincides with that of the rod 72. The axis line of the one nozzle 90 being positioned at the operative position extends in a vertical direction parallel to the axis line about which the index table 20 is rotated, and the one nozzle 90 is moved in a direction intersecting an axial direction thereof when the index table 20 is rotated. Fig. 5 shows one of suction nozzles 90, as a representative thereof. The one suction nozzle 90 includes a suction pipe 91. In the present embodiment, respective lengths of all the suction pipes 91 are equal to each other. Thus, respective distances of respective free end surfaces of the suction pipes 91 from the axis line about which the rotary holder 86 is rotated, are equal to each other.

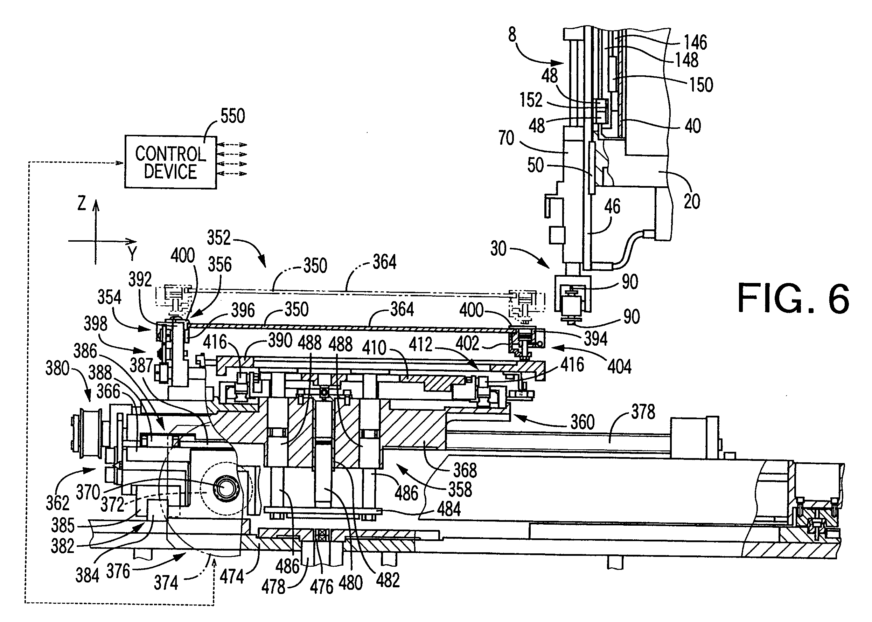

Each suction nozzle 90 is held by the rotary holder 86 such that the each nozzle 90 is not rotatable, but is movable in an axial direction thereof, relative to the holder 86. Each suction nozzle 90 is biased, by a spring 100 as a biasing device that is provided between the each nozzle 90 and the rotary holder 86, in a direction in which the each nozzle 90 advances out of the holder 86. The limit of advancement of the nozzle 90 caused by the biasing action of the spring 100 is defined by the engagement of a pin 102 fitted in the nozzle 90 and extending perpendicularly to the axis line of the nozzle 90, with a wall surface 106 defining an end of an elongate hole 104 formed in the rotary holder 86. Thus, the pin 102 and the wall surface 106 provide respective engaging portions which engage each other and cooperate with each other to provide an advancement-limit defining device. The pin 102 is fitted in the elongate hole 104, such that the pin 102 is movable relative to the hole 104 in the axial direction of the suction nozzle 90. A position of the suction nozzle 90 where the pin 102 is engaged with the wall surface 106 defining the end of the elongate hole 104 and is prevented from being further moved is an advancement-end position of the nozzle 90. From this position, the nozzle 90 can be retracted into the rotary holder 86 while compressing the spring 100. Figs. 1 and 6 show that each EC mounting unit 30 has two suction nozzles 90, for easier illustration purposes only.

The one suction nozzle 90 being positioned at the operative position is connected to a negative-pressure supplying device or an air suction device, not shown, via respective negative-pressure passages 108 of the support shaft 88, the rotary holder 86, the attachment member 84, and the rod 72 (numeral 108 is assigned, in Fig. 3, to only the negative-pressure passage provided in the rod 72), a switch valve 110 as a control valve that is fixed to the sleeve 70, a coupling member 112, a hose 114, and respective negative-pressure passages (not shown) of the index table 20 and the rotary shaft 12. In the present embodiment, each suction nozzle 90 applies a suction or negative pressure to an EC 94 and thereby holds the EC 94. The negative-pressure passage of the support shaft 88 is so formed as to communicate with only the one suction nozzle 90 being positioned at the operative position. In addition, when the rotary holder 86 is rotated, the respective negative-pressure passages of the attachment member 84, the holder 86, and the support shaft 88 are kept communicated with one another. Moreover, when the rotary shaft 12 is rotated, the respective negative-pressure passages of the index table 20 and the rotary shaft 12 are kept communicated with the negative-pressure supplying device or the air suction device.

The switch valve 110 is mechanically switched like the switch valve disclosed in Japanese Patent Document No. 10-126097. When each EC mounting unit 30 is lowered at the EC-receive position, the switch valve 110 is switched to a negative-pressure-supply position thereof to cause the negative-pressure passage 108 to be communicated with the negative-pressure supplying device or the air suction device so that a negative-pressure air is supplied to the suction nozzle 90, and then the switch valve 110 is kept to the negative-pressure-supply position till the EC 94 is mounted on the PWB. When the EC mounting unit 30 is lowered at the EC-mount position to mount the EC 94 on the PWB, the switch valve 110 is switched to a positive-pressure-supply position thereof to supply an atmospheric-pressure air or a positive-pressure air to the suction nozzle 90 so that the EC 94 is released from the nozzle 90.

As shown in Figs. 1 and 3, two EC-mounting-unit elevating and lowering devices 118, 120 are provided at respective portions of the frame 10, and respective portions of the cylindrical cam 40 fixed thereto, that correspond to the EC-receive position and the EC-mount position, respectively. Each of the EC-mounting-unit elevating and lowering devices 118, 120 provides an EC-mounting-unit moving device, a nozzle-holding member moving device, a nozzle moving device, or a moving-toward-and- away device that moves each EC mounting unit 30, moves the nozzle-holding member 74 thereof, or moves the suction nozzle 90 thereof in the axial direction of the nozzle 90. Since the two EC- mounting-unit elevating and lowering devices 118, 120 have the same construction, the elevating and lowering device 118 will be described below as a representative thereof.

At the EC-receive position, there is provided an EC supplying device 122 which supplies ECs 94. In the present embodiment, the EC supplying device 122 includes a plurality of EC-supply feeders 123. The feeders 123 are positioned, on a table 125, and are detachably attached to the table 125, such that respective EC-supply portions of the feeders 123 are arranged along a straight line. Each suction nozzle 90 picks up an EC 94 from the EC-supply portion of each feeder 123. The direction in which the respective EC-supply portions of the feeders 123 are arranged will be referred to as an X-axis direction. When the table 125 is moved in the X-axis direction by a table moving device (not shown) including, as a drive source thereof, a table-drive servomotor 128 (Fig. 8), the EC-supply portion of an appropriate one of the feeders 123 is selectively moved to an EC-supply position which is right below the one EC mounting unit 30 being positioned at the EC-receive position, more specifically described, the one suction nozzle 90 thereof being positioned at the operative position. Each EC mounting unit 30 is lowered and elevated, at the EC-receive position, by the EC-mounting-unit elevating and lowering device 118, so that the one suction nozzle 90 being positioned at the operative position receives an EC 94 from the one feeder 123 being positioned at the EC-supply position. The EC-receive position can be said as an EC-suck position. The movement of the table 125 is guided by a guiding device, not shown, which includes, e.g., a guide block fixed to the table 125 and a guide rail fixed to a base.

The cylindrical cam 40 has, in a portion thereof corresponding to the EC-receive position, a guide groove 144 which opens in the outer circumferential surface of the cam 40 and extends in a vertical direction. An elongate guide rail 146 as a guide member is fixed to a wall surface defining a bottom of the guide groove 144, such that the guide rail 146 extends in a vertical direction parallel to the axial direction of the one suction nozzle 90 being positioned at the operative position and the axis line about which the index table 20 is rotated. Two guide blocks 150 which are fixed to an elevator member 148 as a movable member, are fitted on the guide rail 146 such that the guide blocks 150 are movable on the rail 146. The guide rail 146 and the guide blocks 150 cooperate with each other to provide a guiding device 154 which guides upward and downward movements of the elevator member 148. The elevator member 148 has a width which assures that the elevator member 148 is just fitted in the guide groove 144, and has, in a lower end portion thereof, a horizontal engaging groove 152 which opens on the side of the outer circumferential surface of the cylindrical cam 40 and has the same width (i.e., dimension as measured in a lengthwise direction of the elevator member 148) as that of the cam groove of the cam 40. In a state in which the elevator member 148 is positioned at an upward-movement-end position thereof, the engaging groove 152 takes the same height position as that of one of the horizontal portions of the cam groove of the cylindrical cam 40, and accordingly is continuous with the cam groove.

As shown in Fig. 1, an upper end portion of the elevator member 148 projects upward out of the guide groove 144, and is connected to a lower end portion of a connecting rod 156, via a spherical joint 158, such that the elevator member 148 is rollable or pivotable, but is not movable in an axial direction thereof, relative to the rod 156, and such that a height position of the elevator member 148 is adjustable.

An upper end portion of the connecting rod 156 is connected to a lever 160 via a spherical joint 162, such that the rod 156 is pivotable relative to the lever 160. A rotatable shaft 164 is supported by the frame 10 such that the shaft 164 is rotatable about a horizontal axis line, and the lever 160 is supported by the rotatable shaft 164 such that the lever 160 is not rotatable relative to the shaft 164. The rotatable shaft 164 supports another lever 166 such that the lever 166 is not rotatable relative to the shaft 164. A roller 168 as a cam follower is attached to one end portion of the lever 166, such that the roller 168 is rotatable relative to the lever 166; and a piston rod 172 of an air-operated cylinder device 170 is connected via a pin 173 to the other end portion of the lever 166 such that the piston rod 172 is pivotable relative to the lever 166. When the lever 166 is biased by the air cylinder 170, the roller 168 engages a cam surface 176 of a rotary cam 174 as a sort of cam. The rotary cam 174 is rotated by the previously-described index servomotor 16, and cooperates with the roller 168 to provide a cam device 178. The air cylinder 170 is a double-action-type one and, in a state in which a pressurized air is supplied to one of air chambers of the cylinder 170 and accordingly the roller 168 is pressed against the cam surface 176, if the rotary cam 174 is rotated, the lever 166 is pivoted and accordingly the lever 160 is also pivoted. When the rotary cam 174 is rotated and accordingly the lever 160 is pivoted, the connecting rod 156 is elevated or lowered and accordingly the elevator member 148 is elevated or lowered, so that the EC mounting unit 30 whose rollers 48 have been transferred to the engaging groove 152 is elevated or lowered. Consequently, the nozzle-holding member 74 is lowered and elevated, and the suction nozzle 90 which is being positioned at the operative position and whose axis line is now vertical is lowered and elevated in directions parallel to the axial direction thereof. In the present embodiment, the cam surface 176 has such a shape which assures that first the suction nozzle 90 is smoothly accelerated, then is moved downward at a constant speed, and is smoothly decelerated during a terminal portion of the downward movement. The deceleration of the downward movement is started at a position prescribed depending upon the distance of downward movement. When the EC mounting unit 30 is not elevated or lowered, the roller 168 is not biased by the air cylinder 170 being switched to a different state, and does not follow the cam surface 176.

As schematically illustrated in Fig. 2, an image taking device 300 is provided at the EC-posture-detect position. The image taking device 300 includes a CCD (charge-coupled-device) camera 302 that is a surface-image taking device which can take a two-dimensional image of the EC 94 at once. The CCD camera 302 includes a matrix of CCDs each as a sort of solid image sensor, i.e., a number of small light-receiving elements arranged on a plane. The CCD camera 302 is provided below each EC mounting unit 30 being positioned at the EC-posture-detect position on the locus of revolution of the suction nozzle 90 being positioned at the operative position, such that the camera 302 is oriented upward. A lighting device 304 is provided adjacent to the CCD camera 302, and emits an ultraviolet light toward a lighting plate of each suction nozzle 90, so that the lighting plate emits, from a fluorescent surface thereof, a visible light toward the EC 94 and the CCD camera 302 takes a silhouette image of the EC 94 held by the nozzle 90.

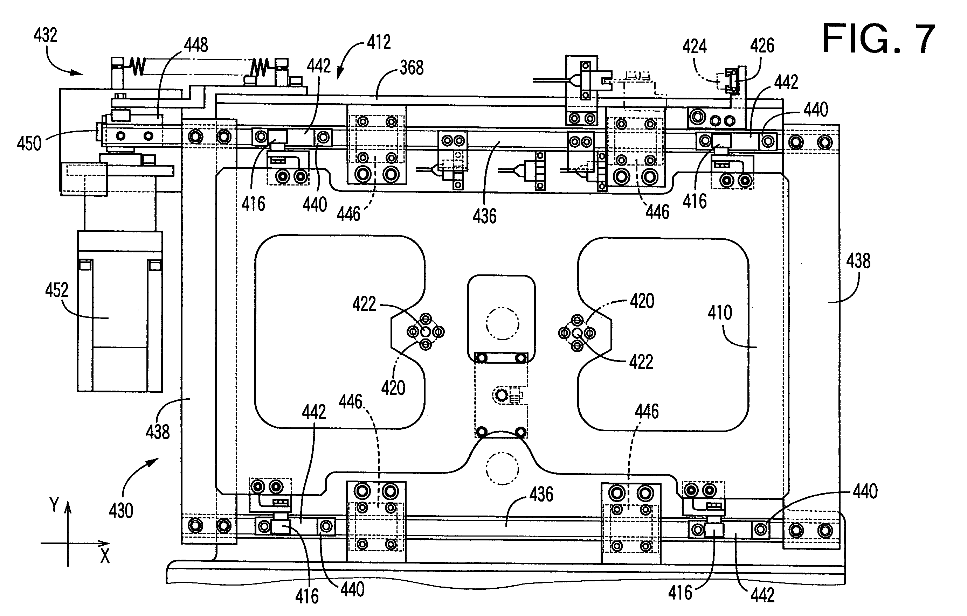

As shown in Figs. 6 and 7, at the EC-mount position, there is provided a wiring-board (WB) supporting and moving device 352 as a circuit-substrate supporting and moving device that supports and moves a printed wiring board (PWB) 350 as a circuit substrate. In the present embodiment, the WB supporting and moving device 352 cooperate with the EC mounting apparatus 8 and the EC supplying device 122 to provide an EC mounting system. In the present embodiment, the WB supporting and moving device 352 has the same construction as that of the WB supporting and moving device disclosed in Japanese Patent Document No. 10-224099 or a corresponding U.S. Patent Application No. 09/ 015,521, and accordingly is briefly described. The WB supporting and moving device 352 essentially includes (1) a WB conveying device 354 which conveys the PWB 350; (2) a WB holding device 356 which positions and holds the PWB 350 conveyed by the WB conveying device 354; (3) a WB-holding-device elevating and lowering device 358 which moves the WB conveying device 354 and the WB holding device 356 in a vertical, Z-axis direction, and elevates and lowers the devices 354, 356 between a WB-transfer height position, indicated at two-dot-chain line in Fig. 6, and an EC-mount height position, indicated at solid line; (4) a height-position adjusting device 360 which adjusts, at the EC-mount height position, a height position of the WB holding device 356; and (5) an X-Y table 362 which supports the WB holding device 356 via the height-position adjusting device 360 and moves the device 356 to an arbitrary position on a horizontal plane.

The X-Y table 362 moves the WB conveying device 354 and the WB holding device 356 being positioned at the EC-mount height position, to an arbitrary position on the horizontal plane, and thereby positions each place on a support surface 364 of the PWB 350 held by the device 356, where an EC 94 is to be mounted, to a position right below the suction nozzle 90 of the EC mounting unit 30 being positioned at the EC-mount position. The support surface 364 is an upper surface of the PWB 350 and, in the present embodiment, a horizontal plane. The X-Y table 362 includes an X table 366 and a Y table 368. The X table 366 is moved in the X-axis direction (i.e., a direction perpendicular to the sheet of Fig. 6) by an X-table moving device 376 including a feed screw 370, a nut 372, and an X-table moving servomotor 374, while the X table 366 is guided by a guiding device 382. As shown in Fig. 6, the guiding device 382 includes a pair of elongate guide rails 384 (only one rail 384 is shown in Fig. 6) which extend parallel to the X-axis direction on a base 474, and a plurality of (e.g., two) guide blocks 385 which are fitted on each of the two guide rails 384 such that the guide blocks 385 are movable in a lengthwise direction of the each rail 384.

The Y table 368 is provided on the X table 366 such that the Y table 368 is movable in the Y-axis direction, and is moved in the Y-axis direction by a Y-table moving device 380 including a feed screw 378, a nut, not shown, and a Y-table moving servomotor, not shown, while the Y table 368 is guided by a guiding device 386. The guiding device 386 includes a pair of elongate guide rails 387 (only one rail 387 is shown in Fig. 6) which extend parallel to the Y-axis direction on the X table 366, and a plurality of (e.g., two) guide blocks 388 which are fitted on each of the two guide rails 387 such that the guide blocks 388 are movable in a lengthwise direction of the each rail 387.

As shown in Fig. 6, the WB conveying device 354 includes a horizontal main frame 390 having a central opening, and a pair of side frames 392, 394 supported by the main frame 390. The WB conveying device 354 additionally includes a pair of conveying belts 396 (only one belt 396 is shown in Fig. 6) which are supported by the side frames 392, 394, respectively, and extend parallel to each other; and a belt moving device 398 which moves the conveying belts 396. When the conveying belts 396 are moved, the PWB 350 is moved in the X-axis direction perpendicular to the sheet of Fig. 6. In a state in which the WB conveying device 354 is positioned at the WB-transfer height position by the WB-holding-device elevating and lowering device 358, the WB conveying device 354 transfers the PWB 350 on which the ECs 94 have been mounted, to a WB carry-out device, not shown, and receives, from a WB carry-in device, not shown, a PWB 350 on which ECs 94 are to be mounted.

The WB holding device 356 includes two fixed clamp members 400 which are fixed to the two side frames 392, 394, respectively; two movable clamp members 402 (only one member 402 on the side of the side frame 394 is shown in Fig. 6) which cooperate with the fixed clamp members 400 to clamp respective end portions of the PWB 350; and a plurality of WB-hold members, not shown, which cooperate with each other to support a lower surface of the PWB 350. The movable clamp members 402 are moved toward, and away from, the fixed clamp members 400, by a drive device including air-operated cylinder devices each as an actuator. In the present embodiment, the fixed clamp members 400 and the movable clamp members 402 cooperate with each other to provide a WB-support member as a substrate-support member; and the WB holding device 356, the main frame 390, and the side frames 392, 394 cooperate with one another to provide a WB supporting device 404 as a substrate supporting device. The EC-mounting-unit elevating and lowering device 120 which vertically elevates and lowers each nozzle-holding member 74 moves the each holder 74 toward, and away from, the WB supporting device 404 in directions perpendicular to a horizontal support surface 364 of the PWB 350 supported by the device 404.

The height-position adjusting device 360 includes a Z table 410 which supports, at the EC-mount height position, a lower surface of the main frame 390; and a Z-table moving device 412 which moves the Z table 410 in the Z-axis direction. As is apparent from Fig. 7, the Z table 410 has four rollers 416 such that each of the rollers 416 is rotatable relative to the table 410. The Z-table moving device 412 includes a wedge-block frame 430; and a wedge-block-frame moving device 432 which moves, on the Y table 368, the wedge-block frame 430 relative to the Y table 368 in the X-axis direction. The wedge-block frame 430 has four wedge blocks 440 each having an inclined surface 442. The wedge-block-frame moving device 432 includes a rack 448 fixed to the wedge-block frame 430; a pinion 350 attached to the Y table 368; and a drive motor 452 which rotates the pinion 450. When the pinion 450 is rotated by the drive motor 452, the wedge-block frame 430 is moved relative to the Y table 368 in the X-axis direction, so that the wedge blocks 440 are moved and, owing to the inclination of the inclined surfaces 442, the Z table 410 is elevated or lowered. Thus, the height position of the PWB 350 can be adjusted when an EC 94 is mounted on the PWB 350. The Z table 410 has two positioning bushings 420 which are engaged with two positioning shafts 422 fixed to the Y table 368, so that the Z table 410 is moved relative to the Y table 368 in only the Z-axis direction (i.e., the vertical direction). The movement of the wedge-block frame 430 is guided by four linear guides 446 fixed to the Y table 368. As shown in Fig. 7, the main frame 390 is provided with a rail 424, and the Y table 368 is provided with a linear guide 426, so that the main frame 390 and the Y table 368 are smoothly moved relative to each other in the Z-axis direction while respective relative positions of the frame 390 and the table 368 in the X-axis and Y-axis directions are prevented from being deviated.

As shown in Fig. 6, the WB-holding-device elevating and lowering device 358 includes (1) an air-operated cylinder device 478 which is provided on the base 474 and includes a piston rod 476; (2) an air-operated cylinder device 482 which is fixed to the Y table 368 and includes a plunger 480; (3) two guide shafts 486 whose upper ends are fixed to the main frame 390 and whose lower ends are connected to the plunger 480 via a connection member 484; and (4) two guide bushings 488 which are fixed to the Y table 368 and are fitted on the two guide shafts 486, respectively, such that the bushings 488 are movable relative to the shafts 486 in the axial direction thereof. The air cylinders 482, the guide shafts 486, and the guide bushings 488 extend in the Z-axis direction.

In a state in which the inner chamber of the air cylinder 482 is communicated with the atmosphere, the piston rod 476 of the air cylinder 478 projects upward in the Z-axis direction. The piston rod 476 projecting upward butts on the connection member 484, thereby pushing up the connection member 484, the guide shafts 486, and the main frame 390. Thus, the PWB 350 is moved up to the WB-transfer height position indicated at two-dot-chain line in Fig. 6. On the other hand, when the inner chamber of the air cylinder 482 is supplied with a pressurized air and the inner chamber of the air cylinder 478 is communicated with the atmosphere, the plunger 480, the guide shafts 486, and the main frame 390 are moved downward, so that the main frame 390 is supported on the Z table 410 and the PWB 350 is moved down to the EC-mount height position indicated at solid line in Fig. 6. In this state, the inner chamber of the air cylinder 482 is constantly supplied with the pressurized air, so that the main frame 390 is pressed against the Z table 410 and the four rollers 416 provided on the Z table 410 are pressed against the four inclined surfaces 442, respectively.

The present EC mounting system is controlled by a control device 550 shown in Fig. 8. The control device 550 is essentially provided by a computer 560 including a PU (processing unit) 552, a ROM (read only memory) 554, a RAM (random access memory) 556, and an input/output section 558. The CCD camera 302 or the like is connected to the input/output section 558, and various actuators such as the index servomotor 16 are also connected to the input/output section 558 via respective drive circuits 562. The drive circuits 562 and the computer 560 cooperate with each other to provide the control device 550. The servomotors employed in the present EC mounting system, such as the index servomotor 16, are electric motors which are accurately controllable with respect to rotation angle and each of which provides a drive source. The rotation angle of each servomotor is detected by an encoder as a rotation detecting device, not shown.

Next, there will be described the operation of the EC mounting system constructed as described above.

In the EC mounting system, the sixteen EC mounting units 30 are sequentially moved to the sixteen stop positions as the index table 20 is intermittently rotated, so that at the EC-receive position, each unit 30 receives an EC 94 and, at the EC-mount position, the each unit 30 mounts the EC 94 on the PWB 350. When the index table 20 is intermittently rotated and the suction nozzles 90 are moved in the direction intersecting the respective axial directions of the nozzles 90, the rollers 48 attached to each of the guide rails 46 roll in the cam groove of the cylindrical cam 40, so that each EC mounting unit 30 is revolved from each stop position to another stop position adjacent to the each stop position, while being lowered and elevated relative to the index table 20. The downward and upward movements of each EC mounting unit 30 including the corresponding nozzle-holding member 74 are guided by the corresponding guiding device 58. That is, the guide rail 46 is moved in the lengthwise direction thereof relative to the guide blocks 50 while being guided by the same 50.

When each EC mounting unit 30 is moved to the EC-receive position, the rollers 48 attached to the guide rail 46 transfer from the cam groove of the cylindrical cam 40 to the engaging groove 152 of the elevator member 148 of the EC-mounting-unit elevating and lowering device 118. Before the rollers 48 has completely transferred to the engaging groove 152, the downward movement of the elevator member 148 is started, so that the EC mounting unit 30 is moved downward. The downward and upward movements of the elevator member 148 are guided by the guiding device 154, and the downward and upward movements of the EC mounting unit 30 are guided by the guiding device 58.

The elevating and lowering device 118 first smoothly accelerates the downward movement of each EC mounting unit 30, subsequently moves the unit 30 at a prescribed, constant speed, and smoothly decelerates the unit 30, so that the suction nozzle 90 contacts the EC 94 at a low speed and without any impact. In the present embodiment, the distance of downward movement of each EC mounting unit 30 is prescribed at a value which is somewhat greater than the distance between the free end surface of the suction nozzle 90 being position at its upward-movement-end position and an upper surface of the EC 94 held by the EC supplying device 122. Thus, the suction nozzle 90 can reliably contact the EC 94 and hold the same 94, and the spring 100 can apply a pressing force to the same 94. An excessive distance of downward movement of the suction nozzle 90 is absorbed by the compression of the spring 100 being retracted toward the rotary holder 86. This compression of the spring 100 applies the pressing force to the EC 94.

The guide rails 46 which hold the corresponding EC mounting units 30 and guide the respective upward and downward movements of the units 30 relative to the index table 20 are provided by respective ceramic products each of which contains silicon nitride as a main component thereof and has a low specific gravity of 3.2. In addition, each of the ceramic products has a high degree of rigidity, is hardly flexed, is hardly vibrated, and has a high vibration-attenuation nature. Therefore, when the intermittent rotation of the index table 20 is started or stopped, that is, when the movement of the suction nozzle 90 in the direction intersecting the axial direction thereof is started or stopped, the guide rail 46 is subjected to an inertial force based on the inertial mass of the rail 46 itself and the inertial masses of the nozzle-holding member 74, etc. However, the guide rail 46 is hardly flexed or vibrated, the vibration of the rail 46 easily attenuates, and the rail 46 reduces the transmission, to the nozzle-holding member 74, of the vibration which is produced by the movement of the table 125 of the EC supplying device 122 and the movements of the X table 366 and the Y table 368 of the WB supporting and moving device 352. Therefore, the free end portion of the suction nozzle 90 being positioned at the operative position is less vibrated in directions perpendicular to the axial direction of the nozzle 90, and accordingly is less deviated from the EC 94 held by the EC-supply feeder 123, so that the nozzle 90 can reliably suck and hold the EC 94. In addition, since the mass of the rail 46 is small, the deceleration of downward movement of the nozzle 90 is started at a position less deviated from the downward-movement-deceleration-start position defined by the shape of the cam surface 176 of the rotary cam 174, when the nozzle 90 is lowered by the EC-mounting-unit elevating and lowering device 118. Therefore, the nozzle 90 contacts the EC 94 at a sufficiently low speed, without applying an excessive impact to the same 94, so that the nozzle 90 can suck and hold the EC 94 without breaking or filliping the same 94. Moreover, since the mass of each rail 46 is small, the index table 20 is subjected to only a small inertial force when the intermittent rotation of the same 20 is started or stopped. Therefore, the table 20 enjoys an improved life expectancy, and a small-size motor can be employed as the index servomotor 16. Since the sixteen EC mounting units 30 are employed in the present embodiment, in particular, and accordingly the sixteen guide rails 46 are employed, a high mass-reduction effect is obtained.

After the suction nozzle 90 holds the EC 94 by applying the negative pressure thereto, the EC mounting unit 30 is moved upward, and then is moved to, and stopped at, the next stop position by an intermittent rotation of the index table 20. Meanwhile, at the EC-posture-detect position, the image taking device 300 takes an image of the EC 94 held by the suction nozzle 90. A batch of image data representing the taken image is compared with a batch of correct image data representing a correct image having no errors, and respective positional errors, Δ X_{E}, Δ Y_{E}, of a center of the EC 94 in the X-axis and Y-axis directions on the horizontal plane, and a rotation-position error, Δ θ , of the EC 94 about its center are determined by the computer 560.

After the image taking operation, the EC mounting unit 30 is moved to the EC-posture-correct position, where the nozzle-holding member 74 is rotated about its own axis line by the EC- posture correcting device to correct the rotation-position error Δ θ of the EC 94, to zero.

After the above-described correction, the EC mounting unit 30 is moved to the EC-mount position, where the unit 30 mounts the EC 94 on the PWB 350. Before the transferring of the rollers 48 attached to the guide rail 46 from the cam groove of the cylindrical cam 40 to the engaging groove 152 of the elevator member 148 of the EC-mounting-unit elevating and lowering device 120 is completed, the downward movement of the elevator member 148 is started, so that the downward movement of the EC mounting unit 30 or the nozzle-holding member 74 is started. The distance of downward movement of the suction nozzle 90 is prescribed at a constant value. The suction nozzle 90 first is smoothly accelerated, subsequently is moved at a constant speed, and then is smoothly decelerated, in the same manner as that in which the nozzle 90 is lowered to suck and hold an EC 94. The deceleration is started at a position prescribed depending upon to the distance of downward movement.

When the EC 94 is mounted on the PWB 350, the PWB 350 is moved along the horizontal plane by the X-Y table 362, so that each EC-mount place on the PWB 350 is positioned at a position right below the suction nozzle 90 which belongs to the EC mounting unit 30 being positioned at the EC-mount position and which is being positioned at the operative position. In the present embodiment, the X-Y table 362 and the intermittently rotating device 32 which intermittently rotates the index table 20, cooperate with each other to provide a displacing device. Respective movement amounts of the X table 366 and the Y table 368 are modified to correct the above-explained center-position errors Δ X_{E}, Δ Y_{E} of the EC 94, respective errors of the X-axis-direction and Y-axis-direction positions of the center of the EC 94 caused by the above-explained correction of the rotation-position error Δ θ of the EC 94, and respective errors, Δ Xₚ, Δ Yₚ, of X-axis-direction and Y-axis-direction positions of each EC-mount place on the PWB 350. In addition, the PWB 350 is elevated or lowered by the height-position adjusting device 360, according to the sort of the EC 94. Thus, the height position of the support surface 364 of the PWB 350 is so adjusted that the EC 94 is mounted on the PWB 350 with an appropriate pressing force.

When the EC mounting unit 30 mounts the EC 94 on the PWB 350, the switch valve 110 is switched to its positive-pressure-supply position during the downward movement of the unit 30, so that the suction nozzle 90 releases the EC 94. Then, the unit 30 is moved to the next stop position by the rotation of the index table 20.

The guiding device 58 additionally guides the upward and downward movements of the EC mounting unit 30 or the nozzle-holding member 74 to cause the suction nozzle 90 to mount the EC 94 on the PWB 350. More specifically described, the guide rail 46 is moved relative to the guide blocks 50 in the lengthwise direction of the rail 46, while guiding the upward and downward movements of the nozzle-holding member 74 in the directions parallel to the axial direction of the suction nozzle 90. Since the guide rail 46 is provided by the ceramic product, the rail 46 is light and highly rigid, and the vibration of the rail 46 easily attenuates. Therefore, when the intermittent rotation of the index table 20 is started and stopped, the guide rail 46 is hardly vibrated and the vibration of the rail 46 easily attenuates, like when the EC 94 is sucked and held. As shown in Fig. 1, each EC mounting unit 30 is positioned, at the EC-mount position, at its downward-movement-end position based on the circumferential-direction change of height position of the cam groove of the cylindrical cam 40, where a lower portion of the guide rail 46 to which the sleeve 70 is fixed extends downward from the lower guide block 50 and an upper portion of the rail 46 to which nothing is fixed are engaged with the two guide blocks 50. Therefore, when the intermittent rotation of the index table 20 is started or stopped, the guide rail 46 would be easily flexed or vibrated because of an inertial force based on the inertial mass of its own and the inertial masses of the nozzle-holding member 74, etc., unless the rail 46 is provided by the ceramic product. That is, since the guide rails 46 are provided by the ceramic products, the vibration of each rail 46 easily attenuates. Unless each guide rail 46 is provided by a ceramic product, the free end portion of the suction nozzle 90 would be more largely vibrated and more likely fail to mount the EC 94, when the nozzle 90 mounts the EC 94 at the position lower than the position where the nozzle 90 sucks and holds the EC 94. Since each guide rail 46 is provided by a ceramic product and accordingly the vibration of the each rail 46 easily attenuates, the vibration of the free end portion of the suction nozzle 90 is reduced and failures to mount ECs 94 on the PWB 350 are decreased.

In addition, since the guide rail 46 reduces the transmission, to the nozzle-holding member 74, of the vibration which is produced by the movement of the table 125 of the EC supplying device 122 and the movement of the X table 366 of the WB supporting and moving device 352, the suction nozzle 90 can mount, with less positional errors, the EC 94 at the corresponding EC-mount place on the support surface 364 of the PWB 350. Moreover, since the mass of each guide rail 46 is small, the deceleration of downward movement of the suction nozzle 90 caused by the EC-mounting-unit elevating and lowering device 120 is started at a position less deviated from the downward-movement-deceleration-start position defined by the shape of the cam surface 176 of the rotary cam 174. Therefore, the EC 94 held by the nozzle 90 can contact the support surface 364 of the PWB 350, at a sufficiently low speed, without applying an excessively large impact to the same 364, so that the EC 94 can be mounted on the PWB 350 without being damaged. Thus, the rate of failures to mount ECs is decreased. Since the guide rails 46 are provided by the ceramic products and accordingly the vibration of the free end portion of each suction nozzle 90 at the time of sucking or mounting an EC 94 is small, the acceleration and deceleration of each intermittent rotation of the index table 20 can be easily increased to shorten a cycle time (i.e., a time duration from a time when one of the EC mounting units 30 is stopped at one of the stop positions to a time when the one unit 30 is moved to, and stopped at, another stop position next to the one stop position) and thereby improve the efficiency of mounting of ECs.

In the illustrated embodiment, the guide rails 46 which guide the respective movements of the nozzle-holding members 74 and the suction nozzles 90 relative to the index table 20 in the directions parallel to the axial directions of the nozzles 90, are provided by the ceramic products. However, the pairs of guide blocks 50 may be provided by ceramic products, or the balls 52 may be provided by ceramic products, and each of those ceramic products may contain silicon nitride as a main component thereof.

In the illustrated EC mounting system, the guide members providing the guiding devices other than the guiding devices 58 including the guide rails 46 and the guide blocks 50 may be provided by ceramic products, and each of those ceramic products may contain silicon nitride as a main component thereof. For example, at least one of the guide rail 146 and the two guide blocks 150 of the guiding device 154 which guides the upward and downward movement of the elevator member 148 of each of the EC-mounting-unit elevating and lowering device 118, 120 may be provided by a ceramic product; at least one of the guide rails 384 and the guide blocks 385 of the guiding device 382 which guides the movement of the X table 366 of the WB supporting and moving device 352 may be provided by a ceramic; and at least one of the guide rails 387 and the guide blocks 388 of the guiding device 386 which guides the movement of the Y table 368 may be provided by a ceramic. In addition, at least one of the guide bushings 420 and the guide shafts 422 which cooperate with each other to guide the upward and downward movement of the Z table 410 may be provided by a ceramic product; and at least one of the guide bushings 488 and the guide shafts 486 which cooperate with each other to guide the upward and downward movement of the main frame 390 relative to the Y table 368 may be provided by a ceramic product. Moreover, at least one of the rail 424 and the linear guide 426 which cooperate with each other to guide the movement of the main frame 390 relative to the Y table 368 to adjust the height position of the PWB 350 may be provided by a ceramic product. At least one of the guide rail and the guide blocks of the guiding device which guides the movement of the table 125 of the EC supplying device 122 may be provided by a ceramic product.

Furthermore, the rod 72 as part of each nozzle-holding member 74 may be provided by a ceramic product and, in addition thereto, or in place thereof, the sleeve 70 which supports the rod 72 such that the rod 72 is rotatable about its axis line may be provided by a ceramic product. At least one of the inner and outer rings of each of the two bearings 80 which cooperate with each other to support the rod 72 such that the rod 72 is rotatable, may be provided by a ceramic product; and the balls each as a rolling member that are provided between the two rings may be provided by a ceramic product.

Each nozzle-holding member 74 may be replaced with one which holds only a single suction nozzle 90.

The EC mounting apparatus 8 may be replaced with one which includes a single nozzle-holding member which holds only a single suction nozzle 90, or a plurality of nozzle-holding members each of which holds only a single suction nozzle 90.

The present invention is applicable to an apparatus or a system for mounting heterogeneous ECs including transistors and resistors.

In the foregoing description, each of the ceramic products that may be employed in the illustrated EC mounting system contains silicon nitride Si₃N₄ as its main component. It is preferred that each ceramic product contain not less than 90 parts by weight of silicon nitride. Each ceramic product containing silicon nitride may be replaced with a different sort of ceramic product containing one of alumina Al₂O₃, zirconia ZrO₂, and silicon carbide SiC as its main component. It is preferred that each of the silicon-nitride-based, alumina-based, zirconia-based, and silicon-carbide-based ceramic products have a specific gravity of 3.0 to 6.5 g/cm³, a Vickers hardness of 1100 to 2500 kg/cm², and an elastic modulus of 2.0 to 4.5 kg/mm²(x10⁴).

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.
An apparatus (8) for mounting an electric component (94) on a circuit substrate (350), the apparatus including a nozzle-holding member (74) which holds a suction nozzle (90) applying a suction to the component and thereby holding the component; a displaceable member (20) which supports the nozzle-holding member and is displaceable in a first direction intersecting an axial direction of the nozzle; a displacing device (32) which displaces the displaceable member in the first direction so that the component held by the nozzle is transferred in the first direction and is positioned at a position above the substrate; a moving device (32, 40, 120) which moves, relative to the displaceable member, the nozzle-holding member downward in a second direction parallel to the axial direction of the nozzle so that the component held by the nozzle is mounted on the substrate; and a guiding device (58) which is provided between the nozzle-holding member and the displaceable member and guides a downward movement of the nozzle-holding member relative to the displaceable member in the second direction, the guiding device including two guide members (46, 50) which are engaged with each other, one (46) of the two guide members being supported by the nozzle-holding member, the other guide member (50) being supported by the displaceable member, so that the one guide member is movable relative to the other guide member, along a straight line, one or each (46, 50) of the two guide members being a ceramic.

## Claims

1. Apparatus (8) for mounting an electric component (94) on a circuit substrate (350), the apparatus comprising:
nozzle-holding means (74) for holding a suction nozzle (90) for applying suction to the electric component to thereby hold the component;
support means (20) for supporting the nozzle-holding means and which is moveable in a first direction intersecting an axis of the suction nozzle;
displacing means (32) for displacing the support means in the first direction so as to transfer a component held by the suction nozzle to a position above the circuit substrate;
moving means (32, 40, 120) for moving, relative to the support means, the nozzle-holding means in a second direction substantially parallel to the axial direction of the suction nozzle to enable the electric component held by the nozzle to be mounted on the circuit substrate; and
guiding means (58) which is provided between the nozzle-holding means and the support means for guiding the movement of the nozzle-holding means relative to the support means in the second direction, the guiding means including two guide members (46, 50), one (46) of the two guide members being supported by the nozzle-holding means, the other guide member (50) being supported by the support means, so that said one guide member is movable relative to said other guide member, at least one (46, 50) of the two guide members being formed from ceramic material.

2. Apparatus according to Claim 1, wherein said one guide member comprises one (46) of an elongate guide rail (46) and a guide block (50) which is engaged with the guide rail such that said one of the guide rail and the guide block is movable relative to the other of the rail and the block in only a lengthwise direction of the rail, and said other guide member comprises said other (50) of the rail and the block.

3. Apparatus according to Claim 2, comprising:
a plurality of nozzle-holding means (74) each for holding a respective one of a plurality of said suction nozzles (90);
the support means comprising a rotatable member (20) for supporting each nozzle-holding means and which is intermittently rotatable about an axis line (12) at a first regular angular pitch, in the first direction intersecting the axial direction of each of the suction nozzles held by the nozzle-holding means;
the displacing means comprising a rotating device (32) for intermittently rotating the rotatable member in the first direction to enable the electric components (94) held by each of the suction nozzles to be positioned at a position above the circuit substrate (350);
the moving means (120) being arranged to move each of the nozzle-holding members in the second direction so as to mount the electric component on the circuit substrate;
said apparatus comprising a plurality of said guiding means (58), each of which is provided between the rotatable member and a respective one of the nozzle-holding means, for guiding movement of a respective nozzle-holding means in the second direction, the guiding means including a plurality of said guide blocks (50) fixed to an outer circumferential surface of the rotatable member (20) such that the guide blocks are equiangularly spaced from each other at a pitch equal to the first angular pitch; and a plurality of said guide rails (46) each of which is attached to a corresponding one of the nozzle-holding members (74).

4. Apparatus according to Claim 2 or Claim 3, wherein at least the guide rail (46) is a ceramic.

5. Apparatus according to any one of Claims 2 to 4, wherein the nozzle-holding means (74) includes a shank portion (72) having a circular transverse cross section, and wherein the apparatus further comprises a tubular member (70) in which the shank portion is fitted such that the shank portion is rotatable relative to the tubular member and is not movable in an axial direction thereof relative to the tubular member, the guide rail (46) being fixed to the tubular member (70).

6. Apparatus according to Claim 5, wherein at least one (72, 70) of the shank portion (72) and the tubular member (70) is a ceramic.

7. Apparatus according to Claim 6, wherein at least the shank portion (72) is a ceramic.

8. Apparatus (8) for mounting an electric component (94) on a circuit substrate (350), the apparatus comprising:
nozzle-holding means (74, 72, 84, 86) for holding a suction nozzle (90) for applying suction to the electric component to thereby hold the component;
support means (20) for supporting the nozzle-holding means and which is movable in a first direction intersecting an axis of the suction nozzle;
means (78, 76) for rotating the nozzle-holding member so as to rotate the suction nozzle about an axis line thereof;
moving means (32, 40, 120) for moving the nozzle-holding means relative to the circuit substrate to enable the electric component held by the suction nozzle to be mounted on the circuit substrate; and
means (70, 72) for connecting the nozzle-holding means (74) to the support means (20) such that the nozzle-holding means is rotatable relative to the support means, the connecting means including two members (70, 72) which are fitted together such that one (72) member which is rotatable relative to the other member (70), at least one (70, 72) of the two members being formed from ceramic material.

9. Apparatus (8) for mounting an electric component (94) on a circuit substrate (350), the apparatus comprising:
holding means (74) for receiving a component holder (90) for holding an electric component;
support means (404) for supporting a circuit substrate on which an electric component held by the component holder is to be mounted;
displacing means (32, 362) for displacing at least one of the holding means and the support means relative to the other along a plane substantially parallel to a surface of a circuit substrate to be supported by the support means;
moving means (32, 40, 120, 358, 360) for moving at least one of the holding means and the support means relative to the other in a direction perpendicular to a surface of a circuit substrate to be supported by the support means; and
at least one (32, 40, 120, 358, 360, 362) of the displacing means and the moving means including guiding means (58, 154, 382, 386, 420, 422, 426, 486) for guiding a relative displacement of the holding means and the support by the displacing means and a relative movement of the holding means and the support means by the moving means, the guiding means including an elongate first member (46, 146, 384, 387, 422, 424, 486) and a second member (50, 150, 385, 388, 420, 426, 488) engaging the first member such that at least one of the first and second members is movable relative to the other in a lengthwise direction of the first member, at least one (46, 146, 384, 387, 422, 424, 486, 50, 150, 385, 388, 420, 426, 488) of the first and second members being formed from ceramic material.

10. Apparatus according to Claim 9, wherein the first member (46, 146, 384, 387, 422, 486) is formed from ceramic material.

11. Apparatus according to any one of Claims 1 to 10, wherein the ceramic contains silicon nitride as a main component thereof.

12. Apparatus according to any one of Claims 2 to 7 and 9 to 11, wherein the guiding means further comprises a plurality of rolling members (52), and the guide rail (46) and the guide block (50) engage each other via the rolling members.

13. Guiding apparatus (58, 154, 382, 386, 420, 422, 424, 426, 486, 488), comprising:
an elongate first member (46, 146, 384, 387, 422, 424, 486); and
a second member (50, 150, 385, 388, 420, 426, 488) engaging the first member such that at least one of the first and second members is movable relative to the other in only a lengthwise direction of the first member;
at least one (46, 146, 384, 387, 422, 424, 486, 50, 150, 385, 388, 420, 426, 488) of the first and second members being formed from ceramic material.

14. Apparatus according to Claim 13, wherein the first member comprises a guide rail (46, 146, 384, 387) and the second member comprises a guide block (50, 150, 385, 388).

15. Apparatus according to Claim 13 or Claim 14, wherein at least the first member (46, 146, 384, 387, 422, 424, 486) is formed from ceramic material.

16. Apparatus according to any one of Claims 13 to 15, further comprising a plurality of rolling members (52), wherein the first member engages the second member (46, 50) via the rolling members.

17. Apparatus according to Claim 16, wherein the plurality of rolling members comprise a plurality of balls (52).

18. Apparatus according to Claim 16 or Claim 17, wherein each of the rolling members (52) is formed from ceramic material.
